# EUROPÄISCHE PATENTSCHRIFT

(11) **EP 3 910 345 B1**
(45) Veröffentlichungstag und Bekanntmachung des Hinweises auf die Patenterteilung: **24.12.2025**
(21) Anmeldenummer: 21168442.8
(22) Anmeldetag: 14.04.2021
(51) Int. Cl.: G01R 11/04, G01R 11/24, G01R 22/06

(54) **ELEKTRIZITÄTSZÄHLER MIT EINEM GEHÄUSE**
ELECTRICITY METER WITH A HOUSING
COMPTEUR D'ÉLECTRICITÉ DOTÉ D'UN BOÎTIER

(30) Priorität: 17.04.2020 DE 102020110531
(43) Veröffentlichungstag der Anmeldung: 17.11.2021
(73) Patentinhaber: EMH metering GmbH & Co. KG, 19258 Gallin (DE)
(72) Erfinder: Kleinwort, Torben, 25590 Osterstedt (DE)
(74) Vertreter: Hauck Patent- und Rechtsanwälte PartmbB

(56) Entgegenhaltungen:
- EP-A1- 2 762 899
- EP-B1- 2 762 899
- GB-A- 2 356 461
- US-A- 5 348 356

## Beschreibung

Die Erfindung betrifft einen Elektrizitätszähler mit einem Gehäuse, das aus einem Gehäuseunterteil und einem Gehäuseoberteil zusammengesetzt ist. Das Gehäuse schützt die im Inneren des Gehäuses angeordneten Elemente des Elektrizitätszählers, beispielsweise eine Leiterplatte, vor Umgebungseinflüssen, unbeabsichtigter Berührung und Manipulationen aller Art.

Um bei möglichst einfacher Montage diesen Anforderungen gerecht zu werden, sind unterschiedliche Rastverbindungen zwischen Gehäuseoberteil und Gehäuseunterteil entwickelt worden. Die Druckschrift EP 1 657 554 B1 zeigt ein Beispiel einer besonders sicheren Rastverbindung. Aus der Druckschrift EP 2 762 899 B1 ist eine andere Rastverbindung bekannt, die bei Bedarf wieder gelöst werden kann, um das Gehäuse zu öffnen.

Bei einem bekannten Elektrizitätszähler aus dem Hause der Anmelderin vom Typ LZQJ-XC weist das Gehäuseoberteil auf einer Seite zwei Laschen auf, die bei der Montage in Aufnahmen im Inneren des Gehäuseunterteils eingehängt werden. Hierzu muss das Gehäuseoberteil in einem bestimmten Winkel auf das Gehäuseoberteil aufgesetzt, exakt positioniert und dann "zugeklappt" werden. Anschließend wird das Gehäuseoberteil auf der anderen Seite mit zwei Plombierschrauben an dem Gehäuseunterteil befestigt.

Aus der Druckschrift GB 2 356 461 A ist ein Elektrizitätszähler mit den Merkmalen des Oberbegriffs des Anspruchs 1 bekannt geworden.

Davon ausgehend ist es die Aufgabe der Erfindung, einen Elektrizitätszähler mit einem Gehäuse zur Verfügung zu stellen, das aus einem Gehäuseunterteil und einem Gehäuseoberteil zusammengesetzt ist, einen sicheren Schutz der im Inneren angeordneten Elemente sowie eine Öffnungsmöglichkeit bietet und das besonders einfach montiert werden kann.

Diese Aufgabe wird gelöst durch den Elektrizitätszähler mit den Merkmalen des Anspruchs 1. Vorteilhafte Ausgestaltungen sind in den Unteransprüchen angegeben.

Der Elektrizitätszähler hat ein Gehäuse, das aus einem Gehäuseunterteil und einem Gehäuseoberteil zusammengesetzt ist, wobei das Gehäuseunterteil und das Gehäuseoberteil auf einer ersten Seite des Gehäuses von im Inneren des Gehäuses angeordneten Verbindungselementen und auf einer der ersten Seite gegenüberliegenden, zweiten Seite des Gehäuses von mindestens einem von außen zugänglichen Verbindungsmittel zusammengehalten sind, wobei die Verbindungselemente Rastelemente aufweisen, die eine Rastverbindung eingehen, wenn die beiden Gehäuseteile in einer Translationsbewegung zusammengesetzt werden, sowie Entriegelungselemente, die die Rastverbindung aufheben, wenn die beiden Gehäuseteile auf der zweiten Seite des Gehäuses auseinandergeklappt werden.

Das Gehäuse ist aus einem Gehäuseunterteil und einem Gehäuseoberteil zusammengesetzt. Als Unterteil wird derjenige Teil des Gehäuses bezeichnet, der bei der Montage in der Regel unten liegt, beispielsweise auf einem Tisch. Einige Elemente des Elektrizitätszählers, beispielsweise eine Leiterplatte, und/oder Anschlussklemmen, können an dem Gehäuseunterteil befestigt sein. Das Gehäuseoberteil wird in der Regel bei der Montage auf das Gehäuseunterteil aufgesetzt. Ist der fertig montierte Elektrizitätszähler in einem Unternehmen oder einem Haushalt installiert, ist das Gehäuseoberteil einem Benutzer zugewandt. Das Gehäuseunterteil kann an einem Montageort an einer Wand zugewandt sein, beispielsweise in einem Schaltschrank. Das Gehäuseoberteil kann aus einem transparenten Material bestehen, insbesondere aus einem transparenten Kunststoffmaterial. Der Elektrizitätszähler kann eine elektronische Anzeige aufweisen, die insbesondere hinter einer Wandung des Gehäuseoberteils angeordnet und von außen ablesbar sein kann. Das Gehäuseoberteil kann einteilig gefertigt sein, insbesondere aus einem transparenten Kunststoffmaterial und/oder in einem Spritzgießverfahren. Dasselbe gilt für das Gehäuseunterteil.

Bei der Erfindung weisen die im Inneren des Gehäuses angeordneten Verbindungselemente Rastelemente auf, die eine Rastverbindung eingehen, wenn die beiden Gehäuseteile in einer Translationsbewegung zusammengesetzt werden. Die Translationsbewegung kann insbesondere in im Wesentlichen senkrechter Richtung zur einer Verbindungsebene des Gehäuses ausgeführt werden. Dadurch kann das Gehäuse sehr einfach und ohne besonderes Fingerspitzengefühl zusammengesetzt werden, auch in Verbindung mit einer automatisierten Fertigung. Im Gegensatz zu den bekannten Elektrizitätszählern vom Typ LZQJ-XC ist es insbesondere nicht erforderlich, das Gehäuseoberteil wie in einem bestimmten Winkel anzusetzen und unter Ausführung einer Rotationsbewegung auf das Gehäuseunterteil abzusenken. Trotz der erheblich vereinfachten Montage ist das Gehäuse durch die Kombination der Rastverbindung mit dem von außen zugänglichen Verbindungsmittel sicher verschlossen.

Eine weitere Besonderheit des Elektrizitätszählers besteht darin, dass die im Inneren angeordneten Verbindungselemente Entriegelungselemente aufweisen, die die Rastverbindung aufheben, wenn die beiden Gehäuseteile auf der zweiten Seite des Gehäuses auseinandergeklappt werden. Demnach kann das Gehäuse bei Bedarf geöffnet werden, indem zunächst das mindestens eine Verbindungsmittel an der zweiten Seite des Gehäuses gelöst bzw. entfernt wird. Die auf der ersten Seite bestehende Rastverbindung öffnet sich durch die Wirkung der Entriegelungselemente automatisch, wenn das Gehäuseoberteil anschließend, dem gewohnten Bewegungsablauf folgend, aufgeklappt wird. Das Auseinanderklappen kann eine Rotationsbewegung um eine Drehachse sein. Die Drehachse kann in einer oder nahe einer Verbindungsebene der beiden Gehäuseteile angeordnet sein. Die Drehachse kann an der ersten Seite des Gehäuses angeordnet sein.

In einer Ausgestaltung weisen die beiden Gehäuseteile entlang einer Verbindungsebene komplementär geformte Konturen auf, die bei geschlossenem Gehäuse die Positionierung der beiden Gehäuseteile relativ zueinander vorgeben. Dies trägt zu einem sicheren Sitz der Gehäuseteile bei und verhindert eine Entriegelung der Rastverbindung bei geschlossenem Gehäuse. Die komplementär geformten Konturen können zum Beispiel eine Nut an einem Rand eines der beiden Gehäuseteile aufweisen, in die eine Feder an einem Rand des anderen Gehäuseteils eingreift, zum Beispiel jeweils erstreckt über eine Seite des Gehäuses oder über einen oder mehrere Abschnitte davon. Möglich sind auch einander laschenartig überlappende Stege an den Rändern der beiden Gehäuseteile. In jedem Fall wird durch die komplementär geformten Konturen ein Verschieben eines Gehäuseteils relativ zu dem anderen Gehäuseteil in der Verbindungsebene bei geschlossenem Gehäuse verhindert.

In einer Ausgestaltung geben die komplementär geformten Konturen nahe der ersten Seite des Gehäuses eine Drehachse für das Auseinanderklappen vor. Mit anderen Worten stützt sich das Gehäuseoberteil beim Auseinanderklappen im Bereich der zusammenwirkenden Konturen an dem Gehäuseunterteil ab. Dadurch bewirken die zusammenwirkenden Konturen eine Führung der Klappbewegung, was das Aufbringen der für die Entriegelung erforderlichen Kräfte erleichtert.

In einer Ausgestaltung weist das Gehäuse eine rechteckige Grundform auf, wobei die beiden kurzen Seiten des Rechtecks die erste Seite und die zweite Seite bilden und die Verbindungselemente paarweise an der ersten Seite nahe den beiden langen Seiten des Rechtsecks angeordnet sind oder umgekehrt. Mit "oder umgekehrt" ist gemeint, dass die beiden langen Seiten des Rechtecks die erste Seite und die zweite Seite bilden und die Verbindungselemente paarweise an der ersten Seite nahe den beiden kurzen Seiten des Rechtsecks angeordnet sind.

Bei der Erfindung weisen die Rastelemente einen von einer Innenseite eines der beiden Gehäuseteile vorstehenden Rastarm und einen damit zusammenwirkenden, an dem anderen Gehäuseteil ausgebildeten Rastvorsprung auf. Der Rastarm kann ein festes, an der Innenseite des jeweiligen Gehäuseteils angeordnetes Ende aufweisen und ein freies Ende, das elastisch verlagerbar ist und so die für das Einrasten erforderliche Bewegung ausführen kann. Der Rastvorsprung kann fest angeordnet oder ebenfalls elastisch verlagerbar ausgeführt sein. In jedem Fall wird ein zuverlässiges, automatisches Einrasten beim Zusammensetzen der Gehäuseteile erreicht.

In einer Ausgestaltung weisen der Rastarm und der Rastvorsprung zusammenwirkende Rastflächen auf, die bei bestehender Rastverbindung aneinander anliegen, wobei die Rastflächen relativ zu einer Drehachse für das Auseinanderklappen so angeordnet sind, dass sich ihr Abstand voneinander beim Auseinanderklappen vergrößert. Die Rastflächen sorgen dafür, dass die beiden Gehäuseteile nicht in Gegenrichtung der beim Zusammensetzen ausgeführten Translationsbewegung auseinandergenommen werden können. Die spezielle Anordnung relativ zu der Drehachse sorgt dafür, dass die für das Auseinanderklappen erforderliche Rotationsbewegung nicht durch die Rastflächen blockiert wird. Insbesondere wenn die Rastflächen einen relativ großen Abstand von der Drehachse aufweisen, kann sich der Abstand zwischen den Rastflächen schon bei einer kleinen Drehbewegung deutlich verändern. Wird dies nicht berücksichtigt, kann die Drehbewegung blockiert werden oder die Rastflächen können bei geschlossenem Gehäuse nicht sauber aneinander anliegen, was zu einer unzuverlässigen Rastverbindung oder einem "Klappern" des Gehäuses führen kann.

Bei der Erfindung weist das Entriegelungselement eine Schrägfläche auf, die so angeordnet ist, dass der Rastarm von dem Rastvorsprung weg verlagert wird, wenn die beiden Gehäuseteile auf der zweiten Seite des Gehäuses auseinandergeklappt werden. Ein mit der Schrägfläche zusammenwirkendes Gegenstück gleitet bei der Klappbewegung an der Schrägfläche ab und wird dadurch seitlich, d.h. bezogen auf eine Drehachse der Klappbewegung in Axialrichtung, verlagert oder verlagert das die Schrägfläche aufweisende Element in dieser Richtung.

In einer Ausgestaltung ist die Schrägfläche an dem Rastarm oder an dem Rastvorsprung ausgebildet. Grundsätzlich kann die Schrägfläche auch an einem anderen, feststehenden Abschnitt eines der beiden Gehäuseteile angeordnet sein, so dass es bei der Klappbewegung auf den Rastarm oder den Rastvorsprung einwirkt. Es ist auch möglich, dass das mit der Schrägfläche zusammenwirkende Gegenstück ebenfalls eine Schrägfläche aufweist, so dass zwei Schrägflächen aneinander abgleiten.

In einer Ausgestaltung ist an dem Rastarm eine Rastöffnung ausgebildet, die den Rastvorsprung ringförmig umschließt. Dadurch wird ein passgenaues und sicheres Einrasten begünstigt.

In einer Ausgestaltung ist der Rastvorsprung an einer Innenseite einer seitlichen Wandung des anderen Gehäuseteils angeordnet. Diese Lösung ist besonders platzsparend. Grundsätzlich kann der Rastvorsprung auch an einem sonstigen Element des anderen Gehäuseteils angeordnet sein, etwa an einem innenliegenden Steg oder an einer Zwischenwand.

In einer Ausgestaltung ist das Gehäuse vor Manipulationen geschützt, so dass es nicht zerstörungsfrei geöffnet werden kann. Damit ist gemeint, dass etwaige Manipulationen nachträglich erkannt werden können, beispielsweise an einem gebrochenen Siegel, einer beschädigten Plombe oder einem zerbrochenen Gehäuseteil.

In einer Ausgestaltung ist das von außen zugängliche Verbindungsmittel eine Plombierschraube. Das Gehäuseoberteil kann dann auf der zweiten Seite durch Einschrauben der Plombierschraube an dem Gehäuseunterteil fixiert werden. Durch Anbringen einer Plombe an der Plombierschraube wird diese Fixierung vor Manipulation geschützt.

Nachfolgend wird die Erfindung anhand eines in Figuren dargestellten Ausführungsbeispiels näher erläutert. Es zeigen:
- Fig. 1: einen Elektrizitätszähler in einer perspektivischen Ansicht,
- Fig. 2: das Gehäuseunterteil des Elektrizitätszählers aus Fig. 1 in einer perspektivischen Ansicht,
- Fig. 3: das Gehäuseoberteil des Elektrizitätszählers aus Fig. 1 in einer perspektivischen Ansicht,
- Fig. 4: den Elektrizitätszähler aus Fig. 1 in einer Ansicht von vorn,
- Fig. 5: einen Schnitt durch den Elektrizitätszähler aus Fig. 1 entlang der in Fig. 4 mit A-A bezeichneten Linie,
- Fig. 6: einen Schnitt durch den Elektrizitätszähler aus Fig. 1 entlang der in Fig. 4 mit B-B bezeichneten Linie,
- Fig. 7: eine vergrößerte Darstellung des in Fig. 5 mit X bezeichneten Ausschnitts und
- Fig. 8: eine vergrößerte Darstellung des in Fig. 6 mit Z bezeichneten Bereichs.

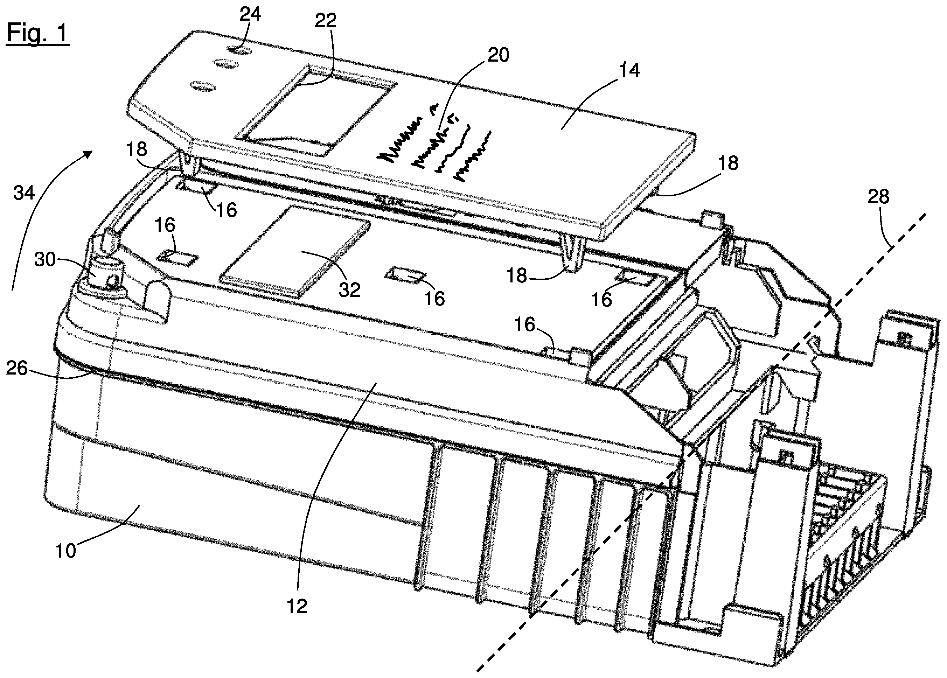

Der Elektrizitätszähler aus Fig. 1 hat ein Gehäuse, das aus einem Gehäuseunterteil 10 und einem Gehäuseoberteil 12 zusammengesetzt ist. An einer einem Benutzer zugewandten Vorderseite des Elektrizitätszählers ist ein Schild 14 aus einem opaken Kunststoffmaterial angeordnet. In der Fig. 1 ist das Schild 14 in einem Abstand von dem Gehäuse gezeigt. An der Vorderseite weist das Schild 14 eine nur angedeutete Beschriftung 20 auf. Im Beispiel handelt es sich um eine Laserbeschriftung, die Buchstaben und Zahlen sowie einen Data Matrix-Code umfasst.

Das Gehäuseoberteil 12 weist fünf Rastöffnungen 16 auf, in die von einer Innenseite des Schilds 14 hervorstehende Rastarme 18 des Schilds einrasten können. Vier der Rastarme 18 befinden sich an den Ecken des im Wesentlichen mit einer rechteckigen Grundform versehenen Schilds 14, ein weiterer, in der Fig. 1 nicht erkennbarer Rastarm 18 befindet sich etwa in der Mitte des Schilds 14. Er rastet in die ebenfalls mittig angeordnete Rastöffnung 16 am Gehäuseoberteil 12 ein.

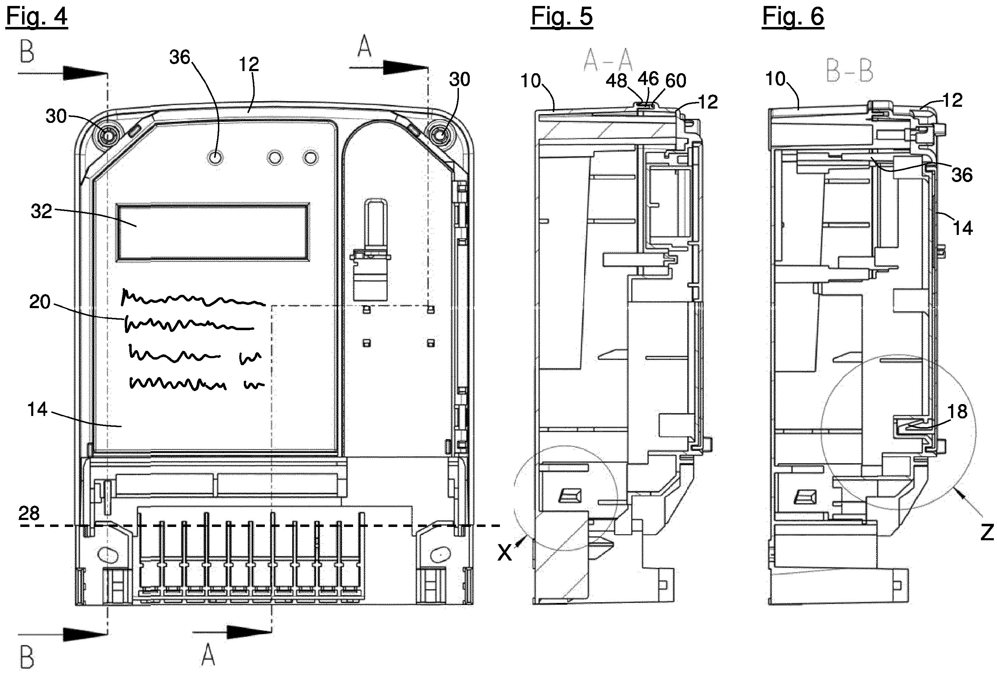

Das Schild 14 hat außerdem eine Durchgangsöffnung 22, die eine elektronische Anzeige 32 des Elektrizitätszählers umgibt. Die Anzeige 32 ist im Inneren des Gehäuses angeordnet und befindet sich hinter einer Wandung des Gehäuseoberteils 12, das aus einem transparenten Kunststoffmaterial besteht. Somit ist die Anzeige 32 von außen durch die Wandung des Gehäuseoberteils 12 und die Durchgangsöffnung 22 des Schilds 14 hindurch ablesbar. Das Schild 14 weist außerdem drei kleinere, kreisförmige Durchgangsöffnungen 24 auf, durch die hindurch am Gehäuseoberteil 12 ausgebildete Lichtleiter 36 (siehe Fign. 4 und 6) zugänglich sind.

Gehäuseunterteil 10 und Gehäuseoberteil 12 grenzen in einer Verbindungsebene 26 aneinander an und sind dort mit komplementär geformten Konturen versehen, die ein seitliches Verrutschen des Gehäuseoberteils 12 relativ zum dem Gehäuseunterteil 10 verhindern.

Das Gehäuse des Elektrizitätszählers weist eine erste Seite auf, die in der Fig. 1 nach rechts weist. Dort ist eine Drehachse 28 angeordnet, um die das Gehäuseoberteil 12 relativ zum Gehäuseunterteil 10 geschwenkt werden kann. Diese Schwenkbewegung um die Drehachse 28 herum ist in der Fig. 1 durch einen Pfeil 34 veranschaulicht.

An der der ersten Seite gegenüberliegenden, zweiten Seite des Gehäuses, die in der Fig. 1 nach links weist, sind zwei Plombierschrauben 30 angeordnet, die das Gehäuseoberteil 12 am Gehäuseunterteil 10 fixieren. Sind die Plombierschrauben 30 eingeschraubt, wie in der Fig. 1 gezeigt, und durch eine Plombe gesichert (in Fig. 1 nicht dargestellt), ist das Gehäuse vor Manipulationen geschützt. Um das Gehäuse zu öffnen, können die Plombierschrauben 30 entfernt werden. Anschließend kann die durch den Pfeil 34 veranschaulichte Bewegung ausgeführt werden, indem die beiden Gehäuseteile 10, 12 auf der zweiten Seite des Gehäuses auseinandergeklappt werden.

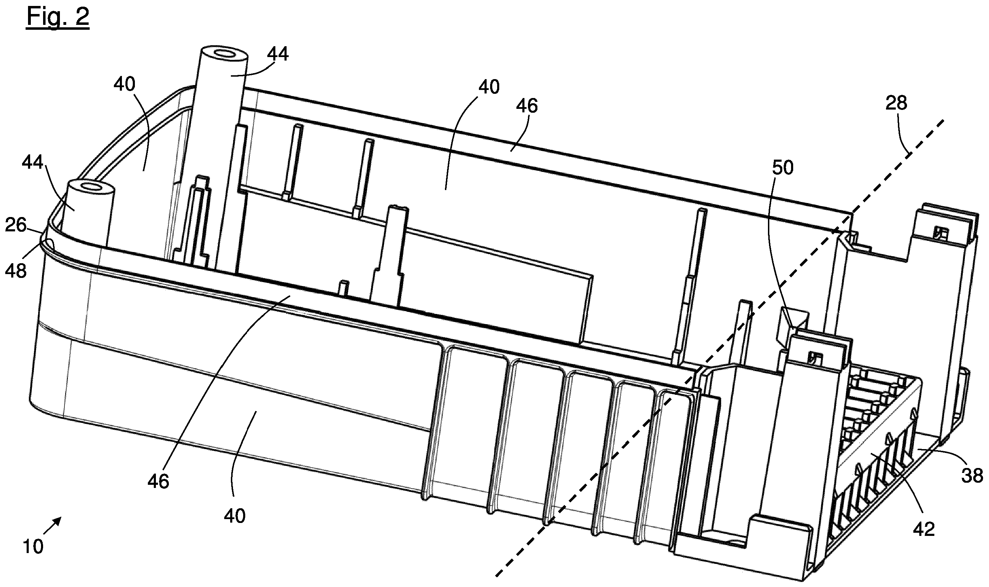

In Fig. 2 ist nur das Gehäuseunterteil 10 des Elektrizitätszählers aus Fig. 1 dargestellt. Das Gehäuseunterteil 10 hat, ebenso wie das Gehäuseoberteil 12, eine im Wesentlichen rechteckige Grundform mit einer in der Fig. 2 nur ansatzweise erkennbaren Rückwand 38 und einer an drei Seiten umlaufenden Seitenwand 40.

An der rechts befindlichen, ersten Seite des Gehäuses ist das Gehäuseunterteil 10 offen. Dort befinden sich ein blockartige Aufnahme 42 für mehrere Anschlussklemmen. An der zweiten Seite des Gehäuses sind zwei säulenartige Aufnahmen 44 für die beiden Plombierschrauben 30 erkennbar.

An ihrem in Fig. 2 nach oben weisenden Rand weist die Seitenwand 40 einen umlaufenden Steg 46 auf, der nach unten von einem ebenfalls umlaufenden Anschlag 48, der in der Verbindungsebene 26 liegt, begrenzt wird. Das Gehäuseoberteil 12 weist hierzu komplementär geformte Konturen auf, sodass die Positionierung der beiden Gehäuseteile 10, 12 relativ zueinander vorgegeben ist.

Hinsichtlich der auf der ersten Seite des Gehäuses vorhandenen Verbindungselemente, die Gehäuseunterteil 10 und Gehäuseoberteil 12 in diesem Bereich zusammenhalten, ist in Fig. 2 ein an der Innenseite der Seitenwand 40 ausgebildeter Rastvorsprung 50 erkennbar. Ein solcher Rastvorsprung 50 befindet sich auch auf der Innenseite der gegenüberliegenden Seitenwand 40, es sind also zwei gleichartige Rastvorsprünge 50 paarweise angeordnet.

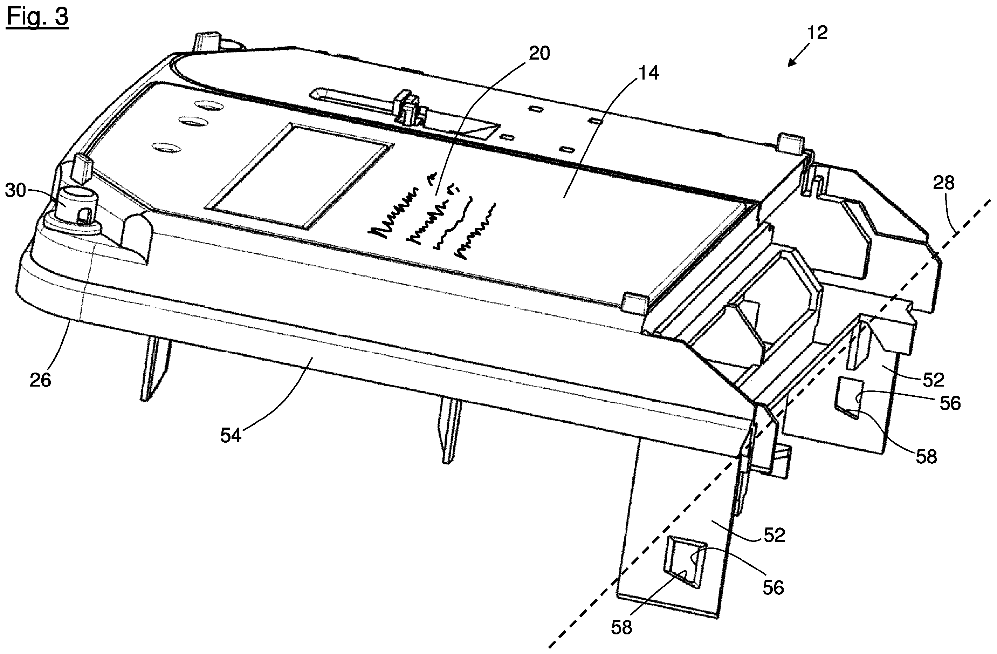

Fig. 3 zeigt das Gehäuseoberteil 12 mit daran befestigten Schild 14. Hinsichtlich der Verbindungselemente sind zwei von einer Innenseite des Gehäuseoberteils 12 hervorstehende Rastarme 52 erkennbar. Sie sind paarweise angeordnet, an einander gegenüberliegenden Enden der ersten Seite, jeweils nahe an einer der langen Seiten der rechteckigen Grundform des Gehäuseoberteils 12 angeordnet. Ein umlaufender, unterer Rand 54 des Gehäuseoberteils 12 läuft um drei Seiten des Gehäuseoberteils 12 um und entspricht der in Fig. 1 eingezeichneten Verbindungsebene 26. Entlang dieses Rands 54 weist das Gehäuseoberteil 12 Konturen auf, die komplementär zu dem Steg 46 und dem Anschlag 48 des Gehäuseunterteils 10 ausgebildet sind. Die Drehachse 28, um die herum das Gehäuseoberteil 12 relativ zum Gehäuseunterteil 10 verschwenkt werden kann, ist in Fig. 3 ebenfalls angedeutet, wie in Fig. 1 durch eine gestrichelte Linie.

Die beiden Rastarme 52 weisen jeweils eine Rastöffnung 56 auf, die im geschlossenen Zustand des Gehäuses einen der Rastvorsprünge 50 am Gehäuseunterteil 10 ringförmig umgibt. Die Rastöffnungen 56 sind trapezförmig mit einer relativ zu der Verbindungsebene 26 geneigt angeordneten Rastfläche 58, die sich jeweils an einem in Fig. 3 unten befindlichen Rand der jeweiligen Rastöffnung 56 befindet.

Das Schild 14 ist in Fig. 3 mit seinen Rastarmen 18 in die Rastöffnungen 16 des Gehäuseoberteils 12 eingerastet und mittels dieser Rastverbindung so befestigt, dass das Schild 14 nicht zerstörungsfrei entfernt werden kann, ohne das Gehäuse zu öffnen.

Fig. 4 zeigt in einer Ansicht von vorn die Anordnung des Schilds 14 am oberen Gehäuseteil 12. Gut erkennbar ist in dieser Ansicht, dass an der zweiten Seite des Gehäuses zwei Plombierschrauben 30 angeordnet sind. Ebenfalls erkennbar sind Lichtleiter 36, die von der Innenseite des Gehäuseoberteils 12 nach innen, also in der Fig. 4 nach hinten, hervorstehen. Sie sind jeweils in einer der Durchgangsöffnungen 24 des Schilds 14 angeordnet. Auch die Anordnung der Anzeige 32 hinter der Durchgangsöffnung 22 des Schilds 14 ist in Fig. 4 erkennbar. Die Drehachse 28 ist wiederum als gestrichelte Linie angedeutet.

In der Schnittdarstellung der Fig. 5 erkennt man ganz oben im Verbindungsbereich zwischen Gehäuseunterteil 10 und Gehäuseoberteil 12 den am Gehäuseunterteil 10 angeordneten Steg 46 sowie eine komplementär dazu geformte Nut 60, die am Gehäuseoberteil 12 umläuft und den Steg 48 aufnimmt.

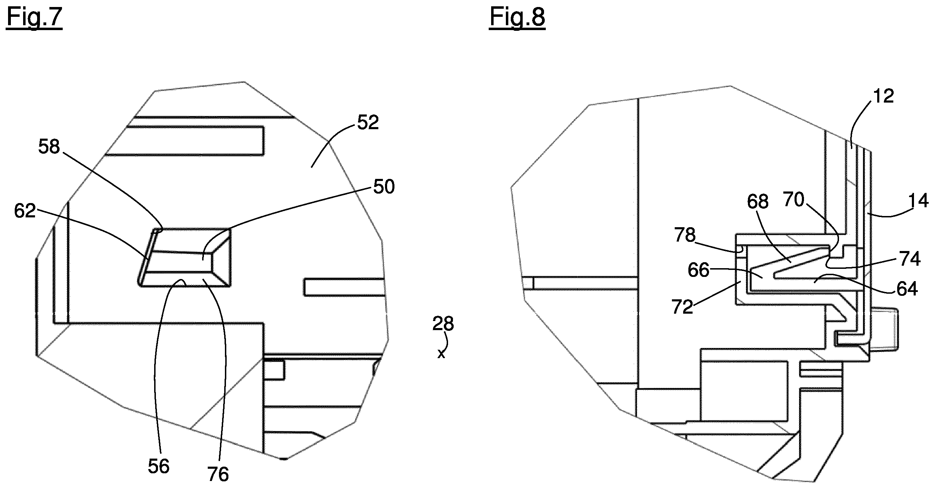

Der mit X bezeichnete Ausschnitt der Fig. 5 ist in Fig. 7 vergrößert dargestellt. Man erkennt einen der beiden Rastarme 52 mit seiner Rastöffnung 56 und dem in dieser Öffnung aufgenommenen Rastvorsprung 50 des unteren Gehäuseteils 12. In dieser Ansicht wird am besten erkennbar, dass die Rastfläche 58 der Rastöffnung 56 an einer Rastfläche 62 des Rastvorsprung anliegt.

Die beiden Rastflächen 58, 62 sind relativ zu der Drehachse 28, die in Fig. 7 durch ein Kreuz angedeutet ist, so angeordnet, dass sich ihr Abstand voneinander beim Auseinanderklappen der beiden Gehäuseteile 10, 12 vergrößert. Bei dieser Auseinanderklappbewegung verbleibt der Rastvorsprung 50 in seiner in Fig. 7 gezeichneten Stellung, während der gesamte Rastarm 52 einschließlich seiner Rastöffnung 56 um die Drehachse 28 herum nach links geschwenkt wird. Durch die Schrägstellung der beiden Rastflächen 58, 62 wird diese Auseinanderklappbewegung durch die Verrastung also nicht blockiert.

Weiter zeigt Fig. 7, dass der Rastvorsprung 50 an seiner in der Fig. 7 nach unten weisenden Seite eine Schrägfläche 76 aufweist. Diese bewirkt bei der beschriebenen Aufklappbewegung eine Entriegelung der Rastverbindung, weil der ebenfalls als Schrägfläche ausgebildete, in der Fig. 7 unten befindliche Öffnungsrand der Rastöffnung 56 an dieser Schrägfläche 76 abgeleitet und dabei den Rastarm 52 nach innen verlagert, bis die beiden Rastflächen 58, 62 ein seitlichen Abstand aufweisen, wodurch die Rastverbindung aufgehoben wird.

In der Schnittdarstellung der Fig. 6 erkennt man den von einer Innenseite des Gehäuseoberteils 12 hervorstehenden Lichtleiter 36, dessen freies Ende bis zu einem optischen Bauteil auf einer nicht dargestellten Leiterplatte des Elektrizitätszählers herangeführt ist. Außerdem erkennt man das etwa bündig zur Außenseite des Gehäuseoberteils 12 eingesetzte Schild 14 sowie einen der Rastarme 18 des Schilds.

Einzelheiten sind besser in der Fig. 8 erkennbar, die den in Fig. 6 mit Z gekennzeichneten Ausschnitt vergrößert darstellt. Dort erkennt man, dass der Rastarm 18 einen ersten Armabschnitt 64 aufweist, der von einer Rückseite des Schilds 14 nach unten weist. An einem freien Ende 66 dieses ersten Armabschnitts 64 schließt sich ein zweiter Armabschnitt 68 an, der sich schräg in Richtung zur Rückseite des Schilds 14 hin erstreckt, wobei sein Ende einen Anschlag 70 bildet.

Weiterhin ist in Fig. 8 erkennbar, dass die Rastöffnung 16 am Gehäuseoberteil 12 einen Öffnungsschacht mit einem geschlossenen Boden 72 bildet. Innerhalb des Öffnungsschachts befindet sich ein Anschlag 74, an dem der Anschlag 70 des zweiten Armabschnitts 68 anliegt. Im Boden 72 des Öffnungsschachts ist eine kleine Entriegelungsöffnung 78 ausgebildet, durch die ein Werkzeug in den Öffnungsschacht eingeführt werden kann, mit dem der zweite Armabschnitt 68 und mit ihm der an seinem Ende ausgebildete Anschlag 70 zu dem ersten Armabschnitt 64 hin verlagert werden kann, um die Verrastung aufzuheben und das Schild 14 zu entfernen.

### Liste der Bezugszeichen

- 10: Gehäuseunterteil
- 12: Gehäuseoberteil
- 14: Schild
- 16: Rastöffnung (für Schild)
- 18: Rastarm (des Schilds)
- 20: Beschriftung
- 22: Durchgangsöffnung (für Anzeige)
- 24: Durchgangsöffnung (für Lichtleiter)
- 26: Verbindungsebene
- 28: Drehachse
- 30: Plombierschraube
- 32: Anzeige
- 34: Pfeil
- 36: Lichtleiter
- 38: Rückwand
- 40: Seitenwand
- 42: Aufnahme für Anschlussklemme
- 44: Aufnahme für Plombierschraube
- 46: Steg
- 48: Anschlag
- 50: Rastvorsprung
- 52: Rastarm
- 54: Rand
- 56: Rastöffnung
- 58: Rastfläche (Rastarm)
- 60: Nut
- 62: Rastfläche (Rastvorsprung)
- 64: erster Armabschnitt
- 66: freies Ende
- 68: zweite Armabschnitt
- 70: Anschlag des zweiten Armabschnitts
- 72: Boden
- 74: Anschlag (im Öffnungsschacht)
- 76: Schrägfläche
- 78: Entriegelungsöffnung

## Patentansprüche

1. Elektrizitätszähler mit einem Gehäuse, das aus einem Gehäuseunterteil (10) und einem Gehäuseoberteil (12) zusammengesetzt ist, wobei das Gehäuseunterteil (10) und das Gehäuseoberteil (12) auf einer ersten Seite des Gehäuses von im Inneren des Gehäuses angeordneten Verbindungselementen und auf einer der ersten Seite gegenüberliegenden, zweiten Seite des Gehäuses von mindestens einem von außen zugänglichen Verbindungsmittel zusammengehalten sind, wobei die Verbindungselemente Rastelemente aufweisen, die eine Rastverbindung eingehen, wenn die beiden Gehäuseteile (10, 12) in einer Translationsbewegung zusammengesetzt werden, wobei die Rastelemente einen von einer Innenseite eines der beiden Gehäuseteile (10, 12) vorstehenden Rastarm (52) und einen damit zusammenwirkenden, an dem anderen Gehäuseteil ausgebildeten Rastvorsprung (50) aufweisen, **dadurch gekennzeichnet, dass** die Verbindungselemente Entriegelungselemente aufweisen, die die Rastverbindung aufheben, wenn die beiden Gehäuseteile (10, 12) auf der zweiten Seite des Gehäuses auseinandergeklappt werden, wobei jedes der Entriegelungselemente eine Schrägfläche (76) aufweist, die so angeordnet ist, dass der Rastarm (52) von dem Rastvorsprung (50) weg verlagert wird, wobei bei der Klappbewegung ein mit der Schrägfläche (76) zusammenwirkendes Gegenstück an der Schrägfläche abgleitet und bezogen auf eine Drehachse der Klappbewegung in Axialrichtung verlagert wird oder das die Schrägfläche (76) aufweisende Element in dieser Richtung verlagert.

2. Elektrizitätszähler nach Anspruch 1, **dadurch gekennzeichnet, dass** die beiden Gehäuseteile (10, 12) entlang einer Verbindungsebene (26) komplementär geformte Konturen aufweisen, die bei geschlossenem Gehäuse die Positionierung der beiden Gehäuseteile (10, 12) relativ zueinander vorgeben.

3. Elektrizitätszähler nach Anspruch 2, **dadurch gekennzeichnet, dass** die komplementär geformten Konturen nahe der ersten Seite des Gehäuses eine Drehachse (28) für das Auseinanderklappen vorgeben.

4. Elektrizitätszähler nach einem der Ansprüche 1 bis 3, **dadurch gekennzeichnet, dass** das Gehäuse eine rechteckige Grundform aufweist, wobei die beiden kurzen Seiten des Rechtecks die erste Seite und die zweite Seite bilden und die Verbindungselemente paarweise an der ersten Seite nahe den beiden langen Seiten des Rechtsecks angeordnet sind oder wobei die beiden langen Seiten des Rechtecks die erste Seite und die zweite Seite bilden und die Verbindungselemente paarweise an der ersten Seite nahe den beiden kurzen Seiten des Rechtsecks angeordnet sind.

5. Elektrizitätszähler nach Anspruch 4, **dadurch gekennzeichnet, dass** der Rastarm (52) und der Rastvorsprung (50) zusammenwirkende Rastflächen (58, 62) aufweisen, die bei bestehender Rastverbindung aneinander anliegen, wobei die Rastflächen (58, 62) relativ zu einer Drehachse (28) für das Auseinanderklappen so angeordnet sind, dass sich ihr Abstand voneinander beim Auseinanderklappen vergrößert.

6. Elektrizitätszähler nach einem der Ansprüche 1 bis 5, **dadurch gekennzeichnet, dass** die Schrägfläche (76) an dem Rastarm (52) oder an dem Rastvorsprung (50) ausgebildet ist.

7. Elektrizitätszähler nach einem der Ansprüche 1 bis 6, **dadurch gekennzeichnet, dass** an dem Rastarm (52) eine Rastöffnung (56) ausgebildet ist, die den Rastvorsprung (50) ringförmig umschließt.

8. Elektrizitätszähler nach einem der Ansprüche 1 bis 7, **dadurch gekennzeichnet, dass** der Rastvorsprung (50) an einer Innenseite einer seitlichen Wandung des anderen Gehäuseteils (10, 12) angeordnet ist.

9. Elektrizitätszähler nach einem der Ansprüche 1 bis 8, **dadurch gekennzeichnet, dass** das Gehäuse vor Manipulationen geschützt ist, so dass es nicht zerstörungsfrei geöffnet werden kann.

10. Elektrizitätszähler nach einem der Ansprüche 1 bis 9, **dadurch gekennzeichnet, dass** das von außen zugängliche Verbindungsmittel eine Plombierschraube (30) ist.

## Claims

1. An electricity meter with a housing which is composed of a housing lower part (10) and a housing upper part (12), wherein the housing lower part (10) and the housing upper part (12) are held together on a first side of the housing by connecting elements arranged inside the housing and are held together on a second side of the housing, opposing the first side, by at least one connecting means which is accessible from outside, wherein the connecting elements have latching elements which create a latching connection when the two housing parts (10, 12) are placed together in a translation movement, wherein the latching elements have a latching arm (52) protruding from an inner face of one of the two housing parts (10, 12) and a latching projection (50) cooperating therewith and configured on the other housing part, **characterized in that** the connecting elements have unlocking elements which cancel the latching connection when the two housing parts (10, 12) are folded apart on the second side of the housing, wherein each of the unlocking elements has an oblique surface (76) which is arranged such that the latching arm (52) is displaced away from the latching projection (50), wherein during the folding movement a counterpart cooperating with the oblique surface (76) slides on the oblique surface and is displaced in the axial direction relative to an axis of rotation of the folding movement or displaces the element having the oblique surface (76) in this direction.

2. The electricity meter according to Claim 1, **characterized in that** along a connecting plane (26) the two housing parts (10, 12) have complementary shaped contours which, when the housing is closed, predetermine the positioning of the two housing parts (10, 12) relative to one another.

3. The electricity meter according to Claim 2, **characterized in that** in the vicinity of the first side of the housing the contours of complementary shape predetermine an axis of rotation (28) for the folding apart.

4. The electricity meter according to one of Claims 1 to 3, **characterized in that** the housing has a rectangular basic shape, wherein the two short sides of the rectangle form the first side and the second side and the connecting elements are arranged in pairs on the first side in the vicinity of the two long sides of the rectangle, or wherein the two long sides of the rectangle form the first side and the second side and the connecting elements are arranged in pairs on the first side in the vicinity of the two short sides of the rectangle.

5. The electricity meter according to Claim 4, **characterized in that** the latching arm (52) and the latching projection (50) have cooperating latching surfaces (58, 62) which bear against one another when the latching connection is present, wherein the latching surfaces (58, 62) are arranged relative to an axis of rotation (28) for the folding apart such that the distance thereof from one another increases during the folding apart.

6. The electricity meter according to one of Claims 1 to 5, **characterized in that** the oblique surface (76) is configured on the latching arm (52) or on the latching projection (50).

7. The electricity meter according to one of Claims 1 to 6, **characterized in that** a latching opening (56), which encloses the latching projection (50) in an annular manner, is configured on the latching arm (52).

8. The electricity meter according to one of Claims 1 to 7, **characterized in that** the latching projection (50) is arranged on an inner face of a lateral wall of the other housing part (10, 12).

9. The electricity meter according to one of Claims 1 to 8, **characterized in that** the housing is protected from manipulation such that it cannot be opened in a nondestructive manner.

10. The electricity meter according to one of Claims 1 to 9, **characterized in that** the connecting means which is accessible from outside is a sealing screw (30).

## Revendications

1. Compteur d'électricité doté d'un boîtier composé d'une partie inférieure de boîtier (10) et d'une partie supérieure de boîtier (12), dans lequel la partie inférieure de boîtier (10) et la partie supérieure de boîtier (12) sont maintenues ensemble sur un premier côté du boîtier par des éléments d'assemblage disposés à l'intérieur du boîtier et sur un deuxième côté du boîtier opposé au premier côté par au moins un moyen d'assemblage accessible depuis l'extérieur, dans lequel les éléments d'assemblage présentent des éléments d'encliquetage s'engageant dans une liaison par encliquetage lorsque les deux parties de boîtier (10, 12) sont réunies dans un mouvement de translation, dans lequel les éléments d'encliquetage présentent un bras d'encliquetage (52) faisant saillie à partir d'un côté intérieur de l'une des deux parties de boîtier (10, 12) et une saillie d'encliquetage (50) coopérant avec celui-ci, formée sur l'autre partie de boîtier, **caractérisé en ce que** les éléments d'assemblage présentent des éléments de déverrouillage supprimant la liaison par encliquetage lorsque les deux parties de boîtier (10, 12) sont écartées par rabattement sur le deuxième côté du boîtier, dans lequel chacun des éléments de déverrouillage présente un biseau (76) disposé de telle façon que le bras d'encliquetage (52) est déplacé à distance de la saillie d'encliquetage (50), dans lequel, lors du mouvement de rabattement, une contre-pièce coopérant avec le biseau (76) glisse sur le biseau et est déplacée dans la direction axiale par rapport à un axe de rotation du mouvement de rabattement ou déplace l'élément doté du biseau (76) dans cette direction.

2. Compteur d'électricité selon la revendication 1, **caractérisé en ce que** les deux parties de boîtier (10, 12) présentent des contour formés de façon complémentaire le long d'un plan d'assemblage (26), lesquels définissent le positionnement des deux parties de boîtier (10, 12) l'une par rapport à l'autre lorsque le boîtier est fermé.

3. Compteur d'électricité selon la revendication 2, **caractérisé en ce que** les contours formés de façon complémentaire définissent un axe de rotation (28) pour l'écartement par rabattement à proximité du premier côté du boîtier.

4. Compteur d'électricité selon l'une des revendications 1 à 3, **caractérisé en ce que** le boîtier présente une forme de base rectangulaire, dans lequel les deux côtés courts du rectangle forment le premier côté et le deuxième côté et les éléments d'assemblage sont disposés par paires sur le premier côté à proximité des deux côtés longs du rectangle ou dans lequel les deux côtés longs du rectangle forment le premier côté et le deuxième côté et les éléments d'assemblage sont disposés par paires sur le premier côté à proximité des deux côtés courts du rectangle.

5. Compteur d'électricité selon la revendication 4, **caractérisé en ce que** le bras d'encliquetage (52) et la saillie d'encliquetage (50) présentent des surfaces d'encliquetage (58, 62) coopérantes, lesquelles s'appliquent les unes contre les autres lorsque la liaison par encliquetage est établie, dans lequel les surfaces d'encliquetage (58, 62) sont disposées de telle façon par rapport à un axe de rotation (28) pour l'écartement par rabattement, que leur distance mutuelle est augmentée lors de l'écartement.

6. Compteur d'électricité selon l'une des revendication 1 à 5, **caractérisé en ce que** le biseau (76) est formé sur le bras d'encliquetage (52) ou sur la saillie d'encliquetage (50).

7. Compteur d'électricité selon l'une des revendications 1 à 6, **caractérisé en ce qu'**une ouverture d'encliquetage (56) est formée sur le bras d'encliquetage (52), laquelle entoure la saillie d'encliquetage (50) de façon annulaire.

8. Compteur d'électricité selon l'une des revendications 1 à 7, **caractérisé en ce que** la saillie d'encliquetage (50) est disposée sur un côté intérieur d'une paroi latérale de l'autre partie de boîtier (10, 12).

9. Compteur d'électricité selon l'une des revendications 1 à 8, **caractérisé en ce que** le boîtier est protégé contre des manipulations, de sorte qu'il ne peut pas être ouvert sans destruction.

10. Compteur d'électricité selon l'une des revendications 1 à 9, **caractérisé en ce que** le moyen d'assemblage accessible depuis l'extérieur est une vis de plombier (30).
